(19) Europäisches Patentamt
European Patent Office
Office européen des brevets

(11) **EP 3 306 331 A1**

(12) **EUROPEAN PATENT APPLICATION**

(43) Date of publication:
**11.04.2018 Bulletin 2018/15**

(51) Int Cl.:
***G01R 31/36*** (2006.01)

(21) Application number: **16193096.1**

(22) Date of filing: **10.10.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB AB**
**721 83 Västerås (SE)**

(72) Inventors:
• **PANG, Zhibo**
**722 42 Västerås (SE)**
• **BAG, Gargi**
**723 44 Västerås (SE)**
• **SCHMITT, Johannes**
**68526 Ladenburg (DE)**

(74) Representative: **Jin, Xiao-Hong**
**ABB AB**
**Intellectual Property**
**Forskargränd 7**
**721 78 Västerås (SE)**

(54) **BATTERY LIFE ESTIMATION**

(57) The present disclosure relates to a method of estimating a battery life time of a Battery-Powered Wireless Device (BPWD) 1. The method comprises, from a Battery Life Estimation Engine (BLEE) 2, retrieving Power Consumption Parameters (PCPs) which are dependent on the deployment of the BPWD. The method also comprises presenting the retrieved PCPs to a user 5 via a User Interface (UI) 4. The method also comprises, in response to the presenting, receiving parameter values of the PCPs from the user over the UI. The method also comprises, based on the received parameter values, and based on predefined parameter values of parameters dependent on the BPWD, estimating, in the BLEE, a battery life time of the BPWD. The method also comprises presenting the estimated battery life time to the user via the UI.

Fig. 1

**Description**

**TECHNICAL FIELD**

The present disclosure relates to a method of estimating a battery life time of a Battery-Powered Wireless Device (BPWD).

**BACKGROUND**

Building/home automation (BA/HA) devices are intended to improve energy efficiency, provide comfort and security to the residents. Emerging wireless Internet of Things (IoT) standards such as Internet Engineering Task Force (IETF) IoT and Thread are considered to play a major role in next generation BA devices. Wireless technologies have advantages over the wired counterpart in terms of ease and cost of installation and retrofit.

Thus, more and more BPWDs are being used in modern Building Automation System (BAS). The adoption of BPWD can ease the system deployment and installation by eliminating all the cables for communication and power supply. However the BPWD is limited by its battery life time which is a concern for system integrators and installers. Device manufacturers have made efforts to reduce the power consumption and thus prolong the battery life of BPWD, but the actual battery life varies a lot when the BPWD is installed in real life systems. A reason for this is that the power consumption for wireless communications varies largely in different design and deployment conditions of a BAS. For example, if there are stronger attenuation, more multipath/reflection, more interference sources, the wireless link quality will be poorer, then the wireless communication packets will be lost more often, why the BPWD will have to retransmit the same packets for more times to guarantee the system functionality and user experience, reducing the battery life, i.e. the time until the battery is empty/fully discharged and needs to be exchanged or recharged. At the same time, if there are more BA devices installed in the given area and/or more traffic is produce by the devices due to e.g. more frequent operation, the possibility of interference will become higher, which will also result in more retransmissions and power consumption. This interference becomes more serious when the wireless network communication is multi-hop, i.e. wireless packets are forwarded by intermediate BA devices between a source device and a target device. It is thus difficult for the device manufacturer to promise some "guaranteed battery life" because these BAS-dependent factors are hard to predict without the knowledge of the design and deployment condition of the BAS.

Existing battery life estimation is done by the device itself during operation e.g. by measuring the voltage of its battery. Thus, it cannot predict the battery life before the device is commissioned, nor can it get sufficient input about the deployment environments which affect the battery life of the wireless device. Therefore the battery life estimation may not be sufficiently accurate.

**SUMMARY**

It has been realised by the inventors, that a more accurate way to estimate the battery life of a BPWD when installed in a BAS is to perform some battery life estimation and optimization by the system integrator during the BAS design phase before field installation. To do this, some information about the power consumption of the BPWD may be shared between the device manufacturer and system integrator. Such information sharing may conveniently be compatible with the well-established engineering tools and processes for BAS filed installation.

Further, there is a need for a common way to describe the parameters which can be understood and configured by device manufacturers, system integrators, and installers during the whole engineering process, why a problem to be solved may be how to efficiently describe Power Consumption Parameters (PCP:s) of the BPWD, then how to use this information by the engineering tool used by the person (user) installing the BPWD, e.g. in a BAS. The definition of a PCP is preferably flexible enough to support various types of devices but also simple enough to be easy-to-use for the user.

According to an aspect of the present invention, there is provided a method of estimating a battery life time of a Battery-Powered Wireless Device (BPWD). The method comprises, from a Battery Life Estimation Engine (BLEE), retrieving Power Consumption Parameters (PCPs) which are dependent on the deployment of the BPWD. The method also comprises presenting the retrieved PCPs to a user via a User Interface (UI). The method also comprises, in response to the presenting, receiving parameter values of the PCPs from the user over the UI. The method also comprises, based on the received parameter values, and based on predefined parameter values of parameters dependent on the BPWD, estimating, in the BLEE, a battery life time of the BPWD. The method also comprises presenting the estimated battery life time to the user via the UI.

According to another aspect of the present invention, there is provided a computer program product comprising computer-executable components for causing a system to perform an embodiment of the method of the present disclosure when the computer-executable components are run on processing circuitry comprised in the system.

According to another aspect of the present invention, there is provided a system for estimating a battery life time of a BPWD. The system comprises a BLEE and a UI. The system is provided with processing circuitry, and storage storing instructions executable by said processing circuitry whereby said system is operative to from the BLEE, retrieve PCPs, which are dependent on the deployment of the BPWD. The system is also operative to present the retrieved PCPs to a user via the UI. The system is also operative to, in response to the presenting, receive parameter values of the PCPs from the user over the UI. The system is also operative to, based on the received parameter values, and based on predefined parameter values of parameters dependent on the BPWD, estimate, in the BLEE, a battery life time of the BPWD. The system is also operative to present the estimated battery life time to the user via the UI.

By means of interaction with the user, e.g. a field installer of the BPWD, over the UI, values of deployment-dependent PCPs may be included in the battery life time estimation, making it more accurate for the actual use of the BPWD. Both deployment-dependent PCPs and PCPs which are not deployment-dependent, typically only device-dependent and thus called such herein, are considered when estimating the battery life time of the BPWD. The values of the device-dependent PCPs may be predefined, e.g. by the manufacturer, while the values of the deployment-dependent PCPs are obtained from the user via a UI.

It is to be noted that any feature of any of the aspects may be applied to any other aspect, wherever appropriate. Likewise, any advantage of any of the aspects may apply to any of the other aspects. Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, step, etc." are to be interpreted openly as referring to at least one instance of the element, apparatus, component, means, step, etc., unless explicitly stated otherwise. The steps of any method disclosed herein do not have to be performed in the exact order disclosed, unless explicitly stated. The use of "first", "second" etc. for different features/components of the present disclosure are only intended to distinguish the features/components from other similar features/components and not to impart any order or hierarchy to the features/components.

## BRIEF DESCRIPTION OF THE DRAWINGS

Embodiments will be described, by way of example, with reference to the accompanying drawings, in which:

Fig 1 is a schematic signalling diagram of embodiments of the method of the present invention.

Fig 2 is a schematic graph illustrating an embodiment of how a current may be composed of different component currents, in accordance with the present invention.

Fig 3 is a schematic graph illustrating embodiments of different operating currents, in accordance with the present invention.

Fig 4 is a schematic flow chart of an embodiment of the method of the present invention.

## DETAILED DESCRIPTION

Embodiments will now be described more fully hereinafter with reference to the accompanying drawings, in which certain embodiments are shown. However, other embodiments in many different forms are possible within the scope of the present disclosure. Rather, the following embodiments are provided by way of example so that this disclosure will be thorough and complete, and will fully convey the scope of the disclosure to those skilled in the art. Like numbers refer to like elements throughout the description.

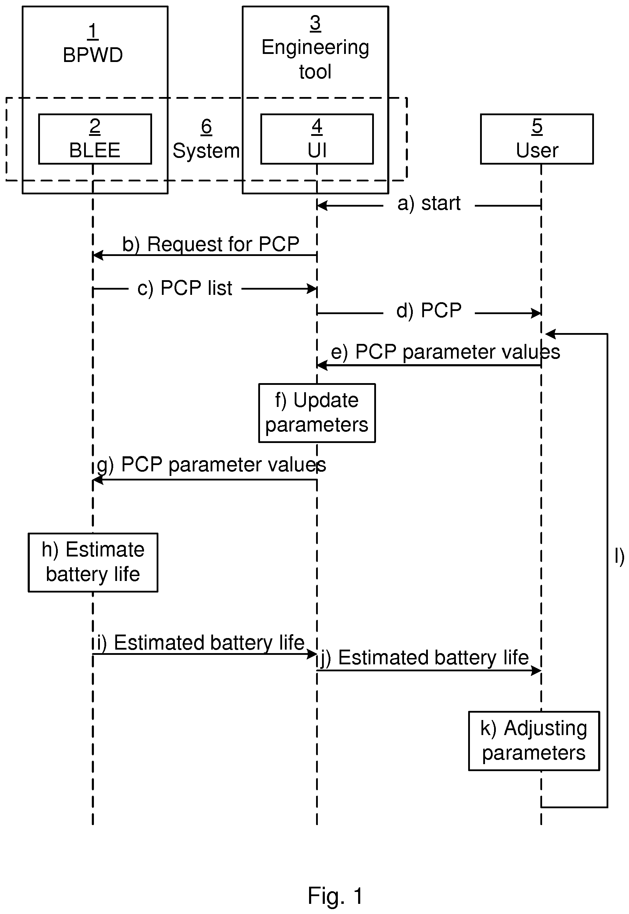

Figure 1 illustrates embodiments of the present invention. A BLEE 2 and a UI 4, comprising appropriate communication interfaces, form a system 6 for estimating a battery life time of a BPWD 1. The system 6 comprises processing circuitry and data storage for storing and executing components, e.g. in the form of software, for performing an embodiment of the method of the present disclosure. The processing circuitry and data storage may be distributed anywhere in the system, e.g. in the BLEE 2 and/or UI 4.

In accordance with the present invention, the system 6 receives is able to communicate with a user 5 via the UI 4 and receives values for deployment-dependent PCPs from said user. The system 6 may have functionality, e.g. in the form of a software application (i.e. an app) located in the BPWD 1 and/or in an engineering tool 3 of the user. In the examples of figure 1, the BLEE 2 is comprised in the BPWD 1 and the UI is comprised in the engineering tool 3. Figure 1 illustrates different method steps of an example embodiment of the estimation method. Some method steps are optional. The method steps of the example embodiment are now discussed below.

a) The user 5 starts the method by interaction with the UI 4. The user 5 may e.g. be the device 1 manufacturer during the device design phase, the system integrator during BAS design phase, the installer during commissioning phase, etc. The UI 4 may e.g. be comprised in any kind of user interface provided by an engineering tool 3 for building automation, e.g. a web page, a Graphical User Interface (GUI), or some command line interface.

b) The UI 4 requests the deployment-dependent PCP parameters from the BLEE 2. The BLEE may e.g. be an embedded software (app) in the BPWD 1.

c) The BLEE 2 returns to the UI 4 the list of PCP parameters which may comprise a series of input parameters which need to be set by via the UI 4. The parameters may be described by a commonly used modelling language of automation systems like OPC UA, oBIX, and generic XML, etc. The list may contain the name, length, type, unit, symbol, range, default value, definition, semantics and/or explanation of the PCP parameters.

d) The UI 4 displays the parameters in proper formats to the user 5.

e) The UI then retrieves input from the User. The User may e.g. set the values of the PCP parameters through the UI, or trigger another software tool, e.g. a system simulator, building information model (BIM), to derive the parameter values needed.

f) The PCP parameters are updated with their respective values in the UI.

g) Then the parameter values/settings are transmitted to the BLEE.

h) The BLEE calculates the estimated battery life (EBL) based on the input parameter values by means of battery life models and formulas.

i) The calculation result is returned to the UI.

j) The calculation result is displayed to the user by the UI.

k) The user considers the estimated battery life time. If it is not satisfactory, the parameters may be adjusted by the user, e.g. the BPWD may be moved to reduce interference or a different battery may be used. The adjustment (optimization) of PCP parameters may be aided or executed by some automatic algorithm.

l) Then, the steps e-k may be repeated for the adjusted parameters.

An example of the list of deployment-dependent PCPs is given below in Table 1.

Table 1

| Symbol | Name | Type | Unit | Definition |
|---|---|---|---|---|
| Idark | Battery Dark Current | float | uA | The average leakage current of the battery to be used installed in the BPWD |
| Q | Battery Capacity | float | mAh | The capacity of the battery to be used installed in the BPWD |
| Fopt | Operations Frequency | Integer | Hz | The number of operations per hour e.g. to send a command from sensor to actuator, to respond to a command from the controller, etc. |
| LQL | Link quality level | Integer | | Simplified estimation about the wireless signal quality including the unknown interferences, shading, reflection, etc. E.g. three levels may be used: high, medium, low. |
| TL | Traffic level | Integer | | Simplified estimation about the traffic created by other wireless devices in the system. It doesn't need to be precise. A recommended format is use 3 levels: high, medium, low. |

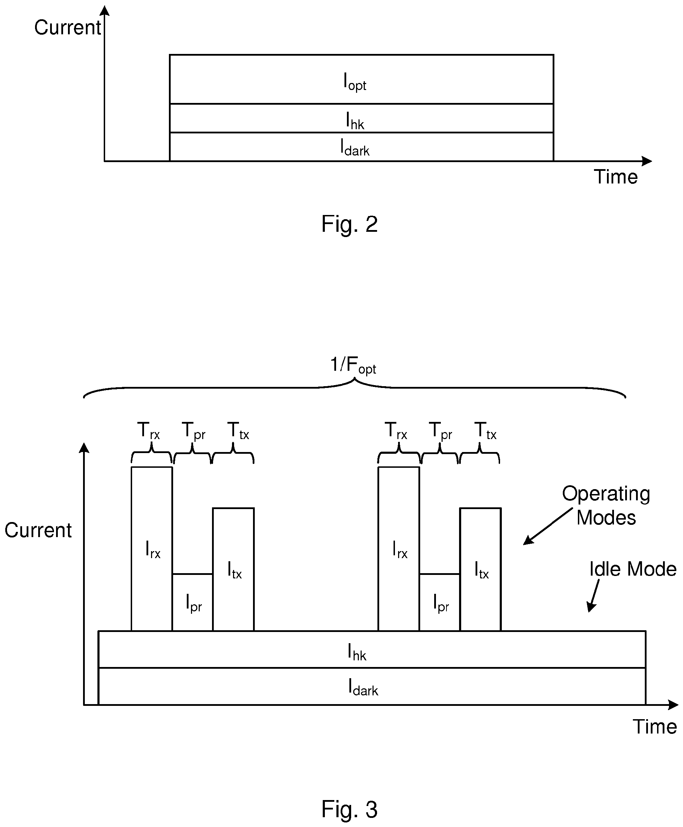

Examples of equations to be used by the BLEE 2 to calculate the estimated battery life (EBL) are given below as equations (1) and (2), where $\overline{I_{opt}}$ is the average current for the device 1 to execute the operations. For better understanding, the physical meaning of equation (1) is illustrated in figure 2. $I_{hk}$ refers to the House-Keeping Current, which is the average current for the device to keep alive in idle mode by executing house-keeping tasks e.g. to keep the wireless network alive, to keep the embedded operation system (OS) alive, and maintain sleeping current of all the hardware components, etc.

$$EBL = \frac{Q}{I_{dark} + I_{hk} + \overline{I_{opt}}} \qquad (1)$$

$$\overline{I_{opt}} = f\left(LQL, TL, F_{opt}\right) \qquad (2)$$

To calculate $\overline{I_{opt}}$, the input parameters LQL, TL, $F_{opt}$, and protocol specific model $f(*)$ may be applied as given in equation (2). The detailed model of $f(*)$ may be implementation specific. One example is given in equation (3), where $K_{repeat}$ is the average number of retransmissions due to packet loss, which is related to LQL and TL by the function $g(*)$ as given in equation (4). The physical meaning of equation (3) is illustrated in figure 3. The device-parameters $I_{tx}$, $I_{rx}$, $I_{pr}$, $T_{tx}$, $T_{rx}$, $T_{pr}$ are the average current and time in transmission state, receiving state, and packet processing state of the BPWD 1, respectively. These may e.g. be measured by experiments by the device manufacturer during development phase.

$$f\left(LQL, TL, F_{opt}\right) = F_{opt} * \left[\sum(I_{tx} * T_{tx}) + \sum(I_{rx} * T_{rx}) + \sum\left(I_{pr} * T_{pr}\right)\right] * K_{repeat} \qquad (3)$$

$$K_{repeat} = g(LQL, TL) \qquad (4)$$

The function $g(*)$ may e.g. be implemented by means of a look-up table based on experimental results done by device 1 manufacturer during development phase. One example is given below in Table 2.

Table 2

| | | Link Quality Level (LQL) | | |
|---|---|---|---|---|
| | | High | Medium | Low |
| Traffic Level (TL) | Low | 1.15 | 2.28 | 3.54 |
| | Medium | 1.53 | 2.88 | 4.23 |
| | High | 2.06 | 3.89 | 6.20 |

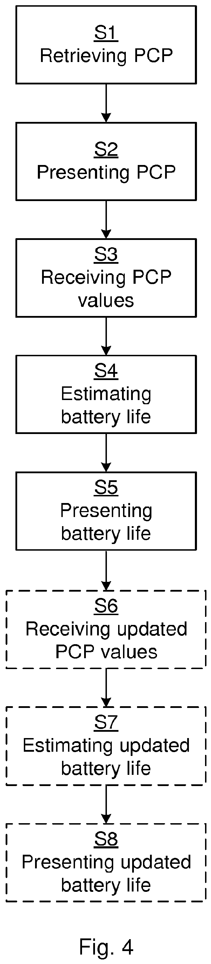

Figure 4 is a schematic flow chart of different embodiments of the method for estimating a battery life time of a BPWD 1, of the present invention. From a BLEE 2, PCPs which are dependent on the deployment of the BPWD are retrieved S1 [e.g. comprising steps b) and/or c) of figure 1]. Then, the retrieved S1 PCPs are presented S2 to a user 5 via a UI 4 [e.g. comprising step d) of figure 1]. In response to the presenting S2, parameter values of the PCPs are received S3 from the user 5 via the UI 4 [e.g. comprising steps e), f) and/or g) of figure 1]. Based on the received S3 parameter values, and based on predefined parameter values of parameters dependent on the BPWD 1, the BLEE 2 estimates S4 a battery life time of the BPWD [e.g. comprising step h) of figure 1]. Then, the estimated S4 battery life time is presented S5 to the user 5 via the UI 4 [e.g. comprising steps i) and/or j) of figure 1].

Optionally, in response to the presenting S5 of the estimated battery life time, updated parameter values of the PCPs are received S6 from the user 5 via the UI 4 [e.g. comprising a second round of steps e), f) and/or g) in figure 1]. Based on the received S6 updated parameter values, and based on the predefined parameter values dependent on the BPWD 1, the BLEE 2 estimates S7 an updated battery life time of the BPWD [e.g. comprising a second round of step h) in figure 1]. Then, the updated battery life time is presented S8 to the user 5 via the UI 4 [e.g. comprising a second round of steps i) and/or j) of figure 1].

In some embodiments of the present invention, the BLEE 2 is comprised in the BPWD 1. In some embodiments, all or at least part of the UI 4 is also comprised in the BPWD 1. Then, the UI 4 may be configured to communicate with the user 5 via an engineering tool 3 of the user 5, the engineering tool being separate from the BPWD 1. In some embodiments, the engineering tool 3 may comprise some other parts of the UI 4, e.g. a GUI.

In some embodiments of the present invention, the UI 4 is comprised in an engineering tool 3 of the user 5, the engineering tool being separate from the BPWD 1. In some embodiments, also at least part of the BLEE 2 is comprised in the engineering tool 3.

The engineering tool 3 may in some embodiments be a specialized engineering device. Alternatively, in some other embodiments, the engineering tool may be a software application in a general purpose computing device such as a smartphone, or a tablet or other portable computer. The engineering tool may be a work tool of the user 5 via which the user may communicate and/or set-up the BPWD 1, e.g. via a user input interface of the engineering tool, such as a GUI or keyboard.

In some embodiments of the present invention, the PCPs include any of: battery dark current ($I_{dark}$), battery capacity ($Q$), operations frequency ($F_{opt}$), link quality level (LQL), and traffic level (TL). However, these are just some examples and any number of other deployment-dependent parameters may be used additionally or alternatively.

In some embodiments of the present invention, the estimating S4 a battery life time of the BPWD comprises determining an average number of retransmissions ($K_{repeat}$) due to packet loss, based on the parameter value of the link quality level (LQL) and/or the parameter value of the traffic level (TL).

In some embodiments of the present invention, the parameters dependent on the BPWD 1 (i.e. the device-dependent parameters/PCPs) include any of: average current in transmission state ($I_{tx}$), average current in receiving state ($I_{rx}$), average current in packet processing state ($I_{pr}$), average time in transmission state ($T_{tx}$), average time in receiving state ($T_{rx}$), and average time in packet processing state ($T_{pr}$). However, these are just some examples and any number of other device-dependent parameters may be used additionally or alternatively.

In some embodiments of the present invention, the method is performed during installation of the BPWD 1 in a BAS. The BPWD 1 may then be a BA device.

The present disclosure has mainly been described above with reference to a few embodiments. However, as is readily appreciated by a person skilled in the art, other embodiments than the ones disclosed above are equally possible within the scope of the present disclosure, as defined by the appended claims.

**Claims**

1. A method of estimating a battery life time of a Battery-Powered Wireless Device, BPWD, (1), the method comprising:

   from a Battery Life Estimation Engine, BLEE, (2), retrieving (S1) Power Consumption Parameters, PCPs, which are dependent on the deployment of the BPWD;
   presenting (S2) the retrieved (S1) PCPs to a user (5) via a User Interface, UI, (4);
   in response to the presenting (S2), receiving (S3) parameter values of the PCPs from the user (5) via the UI (4);
   based on the received (S3) parameter values, and based on predefined parameter values of parameters dependent on the BPWD (1), estimating (S4), in the BLEE (2), a battery life time of the BPWD; and
   presenting (S5) the estimated (S4) battery life time to the user (5) via the UI (4).

2. The method of claim 1, wherein the BLEE (2) is comprised in the BPWD (1).

3. The method of claim 2, wherein at least part of the UI (4) is comprised in the BPWD (1).

4. The method of claim 3, wherein the UI (4) is configured to communicate with the user (5) via an engineering tool (3) of the user (5), the engineering tool being separate from the BPWD (1).

5. The method of claim 1 or 2, wherein the UI (4) is comprised in an engineering tool (3) of the user (5), the engineering tool being separate from the BPWD (1).

6. The method of claim 5, wherein at least part of the BLEE (2) is comprised in the engineering tool (3).

7. The method of any claim 4-6, wherein the engineering tool (3) is a specialized engineering device, or wherein the engineering tool is a software application in a general purpose computing device such as a smartphone, or a tablet or other portable computer.

8. The method of any preceding claim, further comprising:

in response to the presenting (S5) of the estimated battery life time,
receiving (S6) updated parameter values of the PCPs from the user (5) via the UI (4);
based on the received (S6) updated parameter values, and based on the predefined parameter values dependent on the BPWD (1), estimating (S7), in the BLEE (2), an updated battery life time of the BPWD; and
presenting (S8) the updated battery life time to the user (5) via the UI (4).

9. The method of any preceding claim, wherein the PCPs include any of:

   battery dark current ($I_{dark}$), battery capacity (Q), operations frequency ($F_{opt}$), link quality level (LQL), and traffic level (TL).

10. The method of claim 9, wherein the estimating (S4) comprises, based on the parameter value of the link quality level (LQL) and/or the parameter value of the traffic level (TL), determining an average number of retransmissions ($K_{repeat}$) due to packet loss.

11. The method of any preceding claim, wherein the parameters dependent on the BPWD (1) include any of: average current in transmission state ($I_{tx}$), average current in receiving state ($I_{rx}$), average current in packet processing state ($I_{pr}$), average time in transmission state ($T_{tx}$), average time in receiving state ($T_{rx}$), and average time in packet processing state ($T_{pr}$).

12. The method of any preceding claim, wherein the method is performed during installation of the BPWD (1) in a Building Automation System, BAS.

13. A computer program product comprising computer-executable components for causing a system to perform the method of any one of claims 1-12 when the computer-executable components are run on processing circuitry comprised in the system.

14. A system (6) for estimating a battery life time of a Battery-Powered Wireless Device, BPWD, (1), the system comprising:

    a Battery Life Estimation Engine, BLEE, (2); and
    a User Interface, UI, (4);
    the system being provided with:

    processing circuitry; and
    storage storing instructions executable by said processing circuitry whereby said system is operative to:

    from the BLEE (2), retrieve Power Consumption Parameters, PCPs, which are dependent on the deployment of the BPWD;
    present the retrieved PCPs to a user (5) via the UI (4);
    in response to the presenting, receive parameter values of the PCPs from the user (5) over the UI (4);
    based on the received parameter values, and based on predefined parameter values of parameters dependent on the BPWD (1), estimate, in the BLEE (2),
    a battery life time of the BPWD; and
    present the estimated battery life time to the user (5) via the UI (4).

Fig. 1

Current

$I_{opt}$

$I_{hk}$

$I_{dark}$

Time

Fig. 2

$1/F_{opt}$

$T_{rx}$  $T_{pr}$  $T_{tx}$

$T_{rx}$  $T_{pr}$  $T_{tx}$

Operating
Modes

Current

$I_{rx}$

$I_{pr}$

$I_{tx}$

$I_{rx}$

$I_{pr}$

$I_{tx}$

Idle Mode

$I_{hk}$

$I_{dark}$

Time

Fig. 3

Fig. 4

Europäisches
Patentamt

European
Patent Office

Office européen
des brevets

# EUROPEAN SEARCH REPORT

Application Number

EP 16 19 3096

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/235121 A1 (CONSTIEN SCOTT DOUGLAS [US] ET AL) 16 September 2010 (2010-09-16) * abstract; figures 1-9 * * paragraphs [0007] - [0008], [0022] - [0024], [0031] - [0037], [0039], [0046], [0079] - [0091], [0096], [0099] - [0111], [0117] - [0126] * | 1-14 | INV. G01R31/36 |
| A | US 2011/071780 A1 (TARKOMA SASU [FI]) 24 March 2011 (2011-03-24) * paragraph [0032] - paragraph [0034]; figures 1-5 * | 1-14 | |
| A | WO 2008/082288 A1 (GREENPEAK TECHNOLOGIES B V [NL]; VAN PUIJENBROEK CORNELIS ADRIA [NL];) 10 July 2008 (2008-07-10) * abstract; figures 1,3 * * page 1, line 4 - page 2, line 15 * * page 5, line 14 - page 6, line 18 * * page 9, line 17 - page 12, line 17 * * page 15, line 33 - page 16, line 14 * | 1-14 | |

TECHNICAL FIELDS
SEARCHED (IPC)

G01R

The present search report has been drawn up for all claims

| Place of search | Date of completion of the search | Examiner |
|---|---|---|
| Munich | 16 March 2017 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 16 19 3096

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2017

| Patent document cited in search report | Publication date | Patent family member(s) | Publication date |
|---|---|---|---|
| US 2010235121 A1 | 16-09-2010 | NONE | |
| US 2011071780 A1 | 24-03-2011 | US 2011071780 A1<br>WO 2011033378 A1 | 24-03-2011<br>24-03-2011 |
| WO 2008082288 A1 | 10-07-2008 | NONE | |

EPO FORM P0459

For more details about this annex : see Official Journal of the European Patent Office, No. 12/82